# EUROPEAN PATENT APPLICATION

(11) **EP 4 633 340 A1**
(43) Date of publication of application: **15.10.2025**
(21) Application number: 23949417.2
(22) Date of filing: 23.08.2023
(51) Int. Cl.: H10K 59/122, H10K 59/121

(54) **DISPLAY PANEL AND DISPLAY DEVICE**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: MA, Dezhao, Beijing 100176 (CN); GUI, Bingqiang, Beijing 100176 (CN); GAO, Tao, Beijing 100176 (CN)
(74) Representative: Brötz, Helmut
(86) International application number: PCT/CN2023/114513
(87) International publication number: WO 2025/039230

(57) **Abstract**

Provided are a display panel and a display device. The display panel comprises: multiple pixel circuits (100); an insulating material layer (ISL), located on the multiple pixel circuits and comprising multiple organic insulating layers, wherein each organic insulating layer comprises an organic material; multiple pixel electrodes (E1) located on the multiple organic insulating layers and connected to one pixel circuit; a light-emitting function layer (EML) comprising a common layer (CL); and an isolation structure (600) provided with a protrusion (PR) protruding from the organic insulating layers below the isolation structure or itself having a protrusion (PR), wherein the isolation structure (600) is configured to separate the common layer (CL) at the protrusion (PR), the isolation structure (600) is located between adjacent pixel electrodes (E1) and comprises an inorganic material, the isolation structure (600) is located above at least part of the organic insulating layers, and the isolation structure (600) and the multiple pixel electrodes (E1) are at least isolated by part of the organic insulating layers. The display effect is improved, and crosstalk is avoided.

## Description

### TECHNICAL FIELD

Embodiments of the present disclosure relate to a display panel and a display device.

### BACKGROUND

With the continuous development of display technology, organic light-emitting diode (OLED) display devices have become the research hotspot and the direction of technology development for major manufacturers because of its advantages such as wide color gamut, high contrast, thin and light design, self-luminous and wide viewing angle.

At present, organic light-emitting diode display devices have been widely used in various electronic products, which range from small-sized electronic products such as smart bracelets, smart watches, smart phones, tablet computers or the like to large-sized electronic products such as notebook computers, desktop computers, televisions or the like. Therefore, demands for active-matrix organic light-emitting diode display devices from the market are also increasingly growing.

### SUMMARY

Embodiments of the present disclosure provide a display panel and a display device.

Embodiments of the present disclosure provide a display panel, including: a base substrate; a plurality of pixel circuits located on the base substrate; an insulating material layer located at a side of the plurality of pixel circuits facing away from the base substrate and including a plurality of organic insulating layers, each of the plurality of organic insulating layers including an organic material; a plurality of pixel electrodes, each of the plurality of pixel electrodes being located at a side of the plurality of organic insulating layers facing away from the base substrate and connected to one pixel circuit of the plurality of pixel circuits; a light-emitting functional layer including a common layer, an orthographic projection of the common layer on the base substrate overlapping with orthographic projections of the plurality of pixel electrodes on the base substrate, and at least part of the common layer being located at a side of the plurality of pixel electrodes facing away from the base substrate; and a separation structure having a protrusion protruding from the organic insulating layer below the separation structure, or the separation structure itself having a protrusion, the separation structure being configured to disconnect the common layer at the protrusion; the separation structure is located between adjacent pixel electrodes and includes an inorganic material, the separation structure is located on at least part of the organic insulating layer, and the separation structure is spaced apart from the plurality of pixel electrodes by at least part of the organic insulating layer.

For example, the organic insulating layer located below the separation structure has a groove or a first through hole at the protrusion.

For example, the organic insulating layer located above the separation structure has a second through hole at the protrusion, and the first through hole is communicated with the second through hole.

For example, the display panel further includes a pixel defining layer, the pixel defining layer has a plurality of first openings, each of the plurality of first openings is configured to expose one pixel electrode of the plurality of pixel electrodes, and the pixel defining layer further has a second opening which is communicated with the second through hole.

For example, an orthographic projection of the second opening on the base substrate overlaps with an orthographic projection of the separation structure on the base substrate.

For example, the separation structure has one protrusion at the groove or the first through hole.

For example, the groove or the first through hole has an elongated shape, the separation structure includes two separation parts at the groove or the first through hole, and the two separation parts form two protrusions respectively, and the two protrusions are located in the groove or the first through hole and located at two opposite sides of the groove or the first through hole having the elongated shape.

For example, the display panel further includes a common electrode, at least part of the common electrode is located at a side of the light-emitting functional layer facing away from the base substrate, and the plurality of pixel electrodes, the light-emitting functional layer and the common electrode constitute a plurality of light-emitting elements.

For example, the separation structure surrounding one of the plurality of light-emitting elements includes a plurality of separation substructures.

For example, the plurality of separation substructures include at least two separation substructures located at two opposite sides of a light-emitting region of the light-emitting element.

For example, spacing distances between at least one separation substructure of the plurality of separation substructures and two light-emitting elements adjacent thereto are not equal to each other.

For example, the plurality of light-emitting elements include a first light-emitting element, a second light-emitting element and a third light-emitting element, a light-emitting region of the first light-emitting element is smaller than that of the second light-emitting element, the light-emitting region of the second light-emitting element is smaller than that of the third light-emitting element, the separation structure includes a first separation structure and a second separation structure, the first separation structure is located at a periphery of the light-emitting region of the first light-emitting element, and the second separation structure is located at a periphery of the light-emitting region of the second light-emitting element.

For example, the first separation structure includes two first separation substructures located at two opposite sides of the light-emitting region of the first light-emitting element, and the second separation structure includes four second separation substructures arranged around the light-emitting region of the second light-emitting element, two second separation substructures of the four second separation substructures are located at two opposite sides of the light-emitting region of the second light-emitting element, and the other two second separation substructures of the four second separation substructures are located at two opposite sides of the light-emitting region of the second light-emitting element.

For example, the light-emitting region of the first light-emitting element is surrounded by two first separation substructures and two second separation substructures located at gaps of the two first separation substructures, respectively.

For example, the light-emitting region of the third light-emitting element is surrounded by four first separation substructures and two second separation substructures.

For example, the common electrode is continuous at the separation structure.

For example, the first light-emitting element is configured to emit green light, the second light-emitting element is configured to emit red light, and the third light-emitting element is configured to emit blue light.

For example, the separation structure is not in contact with the plurality of pixel electrodes.

For example, the separation structure includes a passivation layer configured to form the protrusion, the inorganic material includes an inorganic nonmetal material, and the inorganic material is an insulating material.

For example, the inorganic material includes a metal material, and the separation structure includes a first sublayer, a second sublayer and a third sublayer which are stacked and arranged in sequence, the first sublayer is closer to the base substrate than the third sublayer to the base substrate, and the third sublayer protrudes outwardly relative to the second sublayer to form the protrusion.

For example, the plurality of organic insulating layers include a first organic insulating layer, a second organic insulating layer, and a third organic insulating layer which are sequentially arranged, the first organic insulating layer is closer to the base substrate than the third organic insulating layer to the base substrate, and the separation structure is located above at least part of the first organic insulating layer and located below at least part of the third organic insulating layer in a direction perpendicular to the base substrate.

For example, the display panel further includes a first connection electrode and a second connection electrode, the pixel circuit includes a transistor, the first connection electrode is located on the first organic insulating layer and connected to the transistor through a via hole passing through the first organic insulating layer, the second connection electrode is located on the second organic insulating layer and connected to the first connection electrode through a via hole passing through the second organic insulating layer, the pixel electrode is located on the third organic insulating layer and connected to the second connection electrode through a via hole passing through the third organic insulating layer.

For example, the insulating material layer further includes an inorganic insulating material layer located between the transistor and the first organic insulating layer, and the first connection electrode also passes through the inorganic insulating material layer.

For example, the display panel has a bending region.

For example, the display panel has a hole region and is provided with a plurality of separation structures, and at least part of the separation structures are located in a bezel region close to the hole region.

Embodiments of the present disclosure provide a display device, including any one of the display panels as described above.

### BRIEF DESCRIPTION OF DRAWINGS

In order to clearly illustrate the technical solution of the embodiments of the present disclosure, the drawings of the embodiments will be briefly described. It is obvious that the described drawings in the following are only related to some embodiments of the present disclosure and thus are not limitative of the present disclosure.
FIG. 1 is a schematic diagram of a light-emitting element.
FIG. 2 is a cross-sectional view of a display panel.
FIG. 3 is a cross-sectional view of a display panel.
FIG. 4 is a plan view of a display panel.
FIG. 5 is a cross-sectional view of a display panel provided by an embodiment of the present disclosure.
FIG. 6 is a partial enlarged view of FIG. 5.
FIG. 7 is a cross-sectional view of a display panel provided by an embodiment of the present disclosure.
FIG. 8 is a partial enlarged view of FIG. 7.
FIG. 9 is a plan view of a display panel provided by an embodiment of the present disclosure.
FIG. 10 to FIG. 14 are cross-sectional views of several display panels provided by embodiments of the present disclosure.
FIG. 15A is a plan view of a display panel provided by an embodiment of the present disclosure.
FIG. 15B is a plan view of a display panel provided by an embodiment of the present disclosure.
FIG. 16A is a schematic diagram illustrating region division of a display panel provided by an embodiment of the present disclosure.
FIG. 16B is a schematic diagram illustrating region division of another display panel provided by an embodiment of the present disclosure.
FIG. 17 is a schematic diagram illustrating region division of another display panel provided by an embodiment of the present disclosure.
FIG. 18 to FIG. 21 are cross-sectional views of several display panels provided by embodiments of the present disclosure.

### DETAILED DESCRIPTION

In order to make objectives, technical details, and advantages of the embodiments of the present disclosure more clear, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first", "second", etc., which are used in the present disclosure, are not intended to indicate any sequence, amount or importance, but distinguish various components. The terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly.

With the continuous development of display technology, people's pursuit of display quality is getting increasingly higher. In order to further reduce the power consumption, prolong the service life and achieve high brightness, a single light-emitting layer included in the light-emitting element of the OLED display panel can be replaced by two light-emitting layers, and a charge generation layer (CGL) is added between the two light-emitting layers in such a manner that an N-type doped charge generation layer and a P-type doped charge generation layer (N/P-CGL) are used as heterojunctions which connect two light-emitting elements in series to form a double-stack design and constitute a tandem structure. The display panel with a tandem structure realizes the series connection between two light-emitting elements, thus greatly reducing light-emitting current of the light-emitting elements and prolonging the service life of the light-emitting elements given the same light-emitting intensity, which is conducive to the development and mass production of new technologies with longer service life such as vehicle-mounted products. The display device with a tandem structure has the advantages of long service life, low power consumption and high brightness.

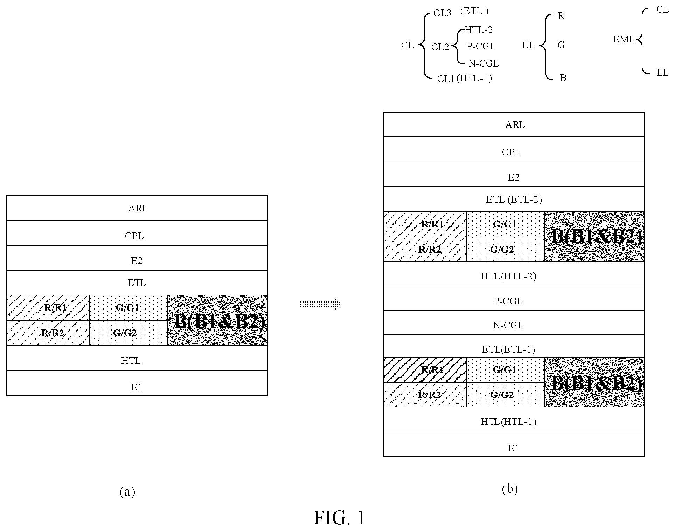

FIG. 1 is a schematic diagram of a light-emitting element. FIG. 1(a) is a schematic diagram of a general light-emitting element. FIG. 1(b) is a schematic diagram of a light-emitting element with tandem structure. As shown in FIG. 1(b), the charge generation layers (CGL) between different light-emitting elements with tandem structure are connected.

FIG. 1 shows a pixel electrode E1, a common electrode E2, a hole transport layer HTL, an electron transport layer ETL, an optical coupling layer CPL, an antireflection layer ARL, a P-type doped charge generation layer P-CGL, an N-type doped charge generation layer N-CGL, a light-emitting layer R, a light-emitting layer G and a light-emitting layer B. As shown in FIG. 1, the hole transport layer HTL includes a hole transport layer HTL-1 and a hole transport layer HTL-2. As shown in FIG. 1, the electron transport layer ETL includes an electron transport layer ETL-1 and an electron transport layer ETL-2.

As shown in FIG. 1, the light-emitting layer R includes two sublayers containing a light-emitting material R1 and a light-emitting material R2, respectively; the light-emitting layer G includes two sublayers containing a light-emitting material G1 and a light-emitting material G2, respectively; and the light-emitting layer B includes a light-emitting material B1 and a light-emitting material B2, respectively. The light-emitting material R1 and the light-emitting material R2 are two different materials that emit red light; the light-emitting material G1 and the light-emitting material G2 are two different materials that emit green light; and the light-emitting material B1 and the light-emitting material B2 are two different materials that emit blue light.

FIG. 1 shows a light-emitting functional layer EML located between the pixel electrode E1 and the common electrode E2, and the light-emitting functional layer EML includes a common layer CL and a local layer LL. The local layer LL includes a light-emitting layer R, a light-emitting layer G, and a light-emitting layer B. The common layer CL includes a first common layer CL1, a second common layer CL2, and a third common layer CL3. As shown in FIG. 1, the first common layer CL1 includes the hole transport layer HTL-1; the second common layer CL2 includes the electron transport layer ETL-1, the charge generation layer N-CGL, the charge generation layer P-CGL, and the hole transport layer HTL-2; and the third common layer CL3 includes the electron transport layer ETL-2.

For example, the common layer CL can be made by using an open mask, and the local layer LL can be made by using a fine metal mask, but the present disclosure is not limited to this.

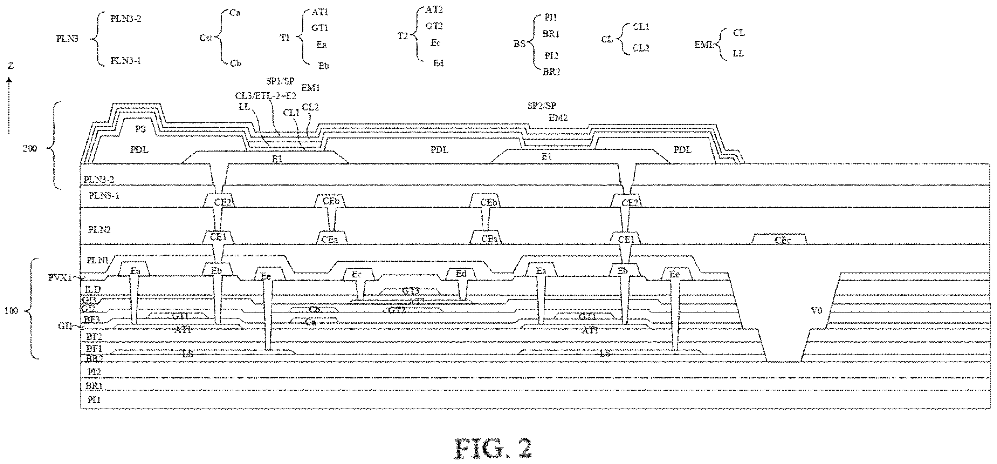

FIG. 2 is a cross-sectional view of a display panel. As shown in FIG. 2, the display panel includes a plurality of sub-pixels SP. FIG. 2 shows a sub-pixel SP1 and a sub-pixel SP2. A plurality of pixel circuits 100 and a plurality of light-emitting elements 200 are provided. As shown in FIG. 2, the pixel circuit 100 includes a transistor T1 and a transistor T2. FIG. 2 shows a light-emitting element EM1 and a light-emitting element EM2. For example, the light-emitting element 200 includes an organic light-emitting diode, but the present disclosure is not limited thereto.

The inventor(s) has/have noticed that for high-resolution products, the common layer CL, such as the charge generation layer, is shared by multiple sub-pixels. Because of its high doping concentration, the charge generation layer has strong conductivity, and the charge generation layers in light-emitting functional layers of adjacent sub-pixels are connected; as a result, layers with high conductivity in the common layer CL, such as the charge generation layers, are liable to cause crosstalk between adjacent sub-pixels, which affects the image quality of the products, and hence seriously influences the display quality.

For example, the crosstalk between adjacent sub-pixels refers to the case where a light-emitting element that should not emit light emits light. As shown in FIG. 2, it's desirable that the light-emitting element EM1 emits light but the light-emitting element EM2 does not emit light; however, due to the conductivity of the charge generation layer, the light-emitting element EM2 will also emit light, which results in lateral leakage and crosstalk.

In order to alleviate or avoid the lateral leakage, separation pillars and other structures can be provided, which can improve the image quality and especially is beneficial to improving low gray-scale image quality.

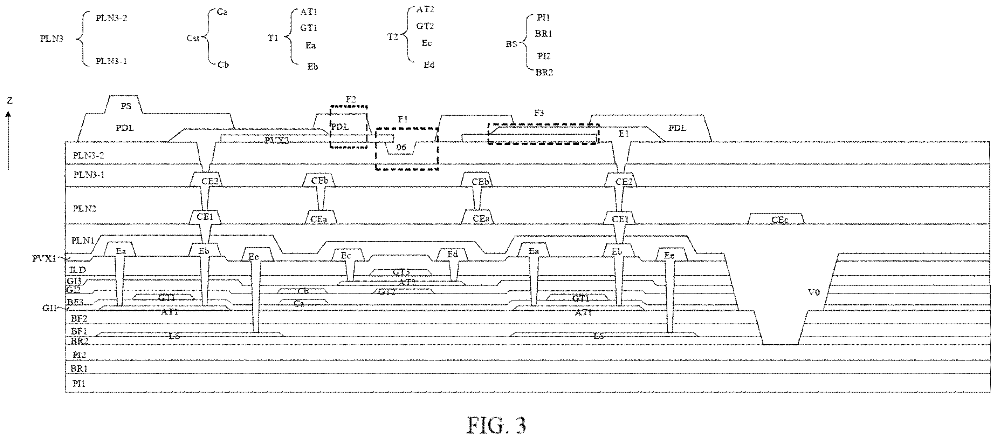

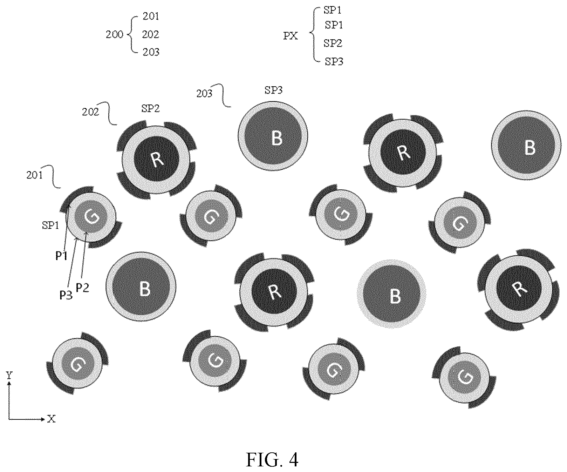

FIG. 3 is a cross-sectional view of a display panel. FIG. 4 is a plan view of a display panel.

As shown in FIG. 3, a separation structure 06 is provided (at the dotted box F1). By arranging a passivation layer PVX2 on a planarization layer PLN3, and by arranging a groove or a through hole in the planarization layer PLN3 at a position where the passivation layer PVX2 is provided, a separation structure 06 for separating the common layer in the light-emitting functional layer can be formed, so as to alleviate or avoid lateral leakage and improve the image quality.

FIG. 4 shows a sub-pixel SP1, a sub-pixel SP2, and a sub-pixel SP3. For example, two sub-pixels SP1, one sub-pixel SP2, and one sub-pixel SP3 constitute one repeating unit PX. The sub-pixel SP1 includes a light-emitting element 201, the sub-pixel SP2 includes a light-emitting element 202, and the sub-pixel SP3 includes a light-emitting element 203. A sub-pixel is shown as a light-emitting region of a light-emitting element of the sub-pixel. As shown in FIG. 4, the position P2 indicates an outer edge of the light-emitting region of the light-emitting element of the sub-pixel. The position P3 indicates an outer edge of the passivation layer PVX2 for forming the separation structure 06. The position P1 is the position where the separation structure 06 is located. The outermost arc-shaped part of the light-emitting element shown in FIG. 4 is an opening in a pixel defining layer PDL that exposes the separation structure 06.

For example, as shown in FIG. 3, a size of the passivation layer PVX2 is about 3µm larger than that of the pixel electrode. For example, the size of the passivation layer PVX2 is greater than 20µm, and an interval between adjacent passivation layers PVX2 is about 5µm, which leads to a serious shortage of space for pattern design. As shown in FIG. 3, in order to expose the separation structure 06, an outer boundary of the pixel defining layer PDL must be smaller than that of the passivation layer PVX2.

However, the display panel shown in FIG. 3 has at least one of the following problems. Firstly, the passivation layer PVX2 is arranged between the pixel electrode E1 and the planarization layer PLN3 (as shown at the dotted box F3), and a flatness of the passivation layer PVX2 is lower than that of the planarization layer, which makes the pixel electrode E1 uneven, which leads to a decrease in light efficiency and is not conducive to improving the display effect. Secondly, because the pixel defining layer PDL is in contact with the passivation layer PVX2 for forming the separation structure 06 (at the dotted box F2), it is liable for the pixel defining layer PDL to be peeled off from the passivation layer PVX2. Thirdly, the passivation layer PVX2 for forming the separation structure 06 has a relatively larger area, which is not conducive to an outgas of the planarization layer below it. Fourthly, due to a spacing limitation between pixel electrodes, only a one-sided separation structure can be arranged. Fifthly, the passivation layer PVX2 seriously affects the bending performance of the display panel.

For other structures in FIG. 2 and FIG. 3, reference can be made to the illustrations in other cross-sectional views, which will not be described here.

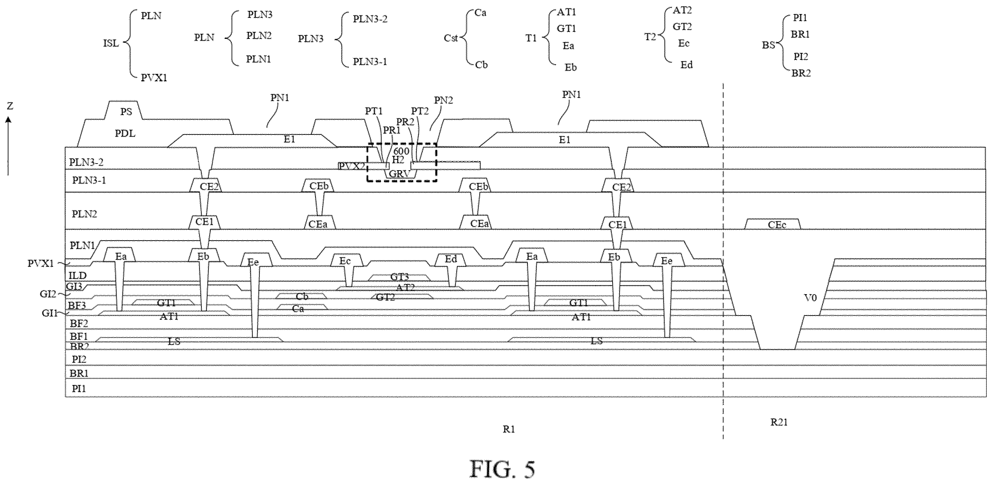

Embodiments of the present disclosure provide a display panel and a display device including the display panel. The pixel electrode E1 and the separation structure are spaced apart from each other by at least part of the planarization layer, which is beneficial to planarizing the pixel electrode E1 and improving the display effect. Hereinafter, description will be given with reference to FIG. 5 to FIG. 21.

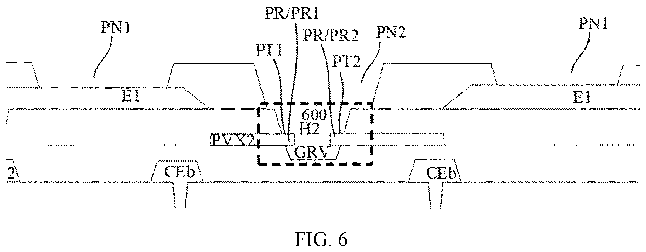

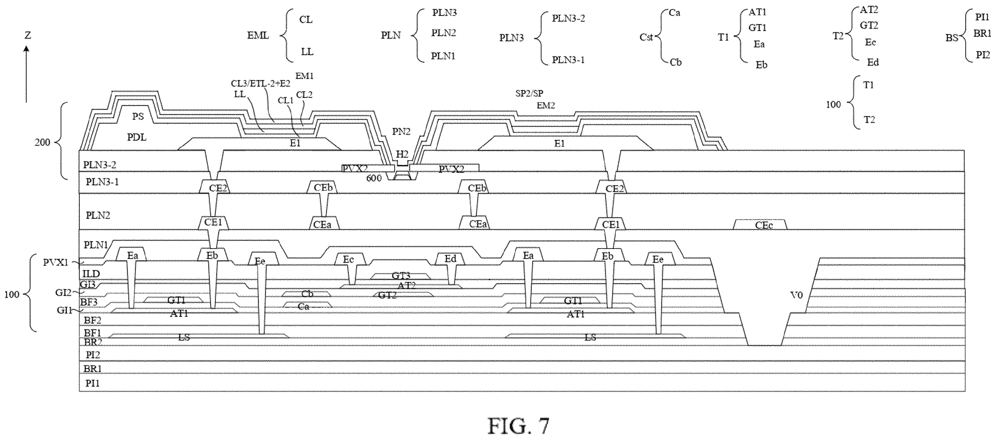

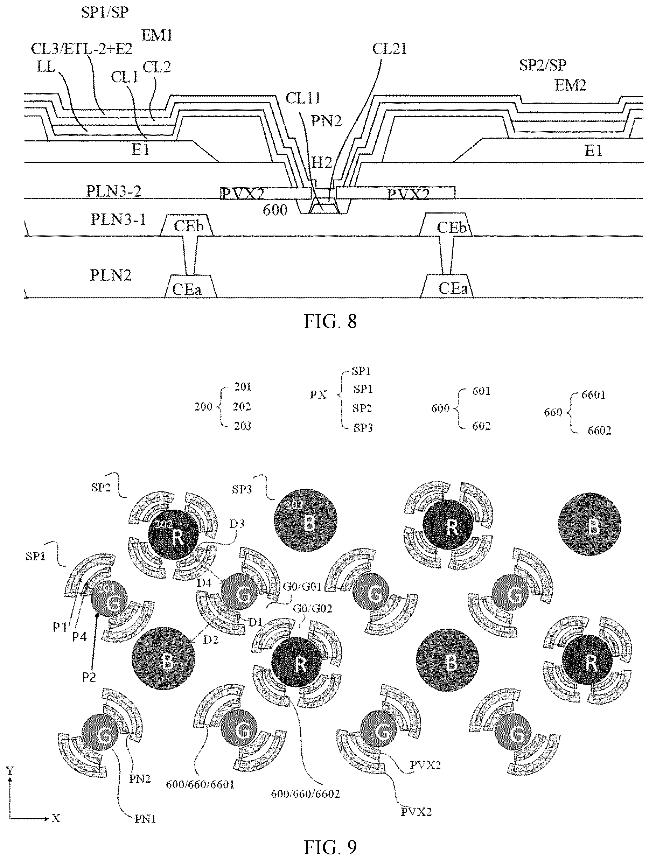

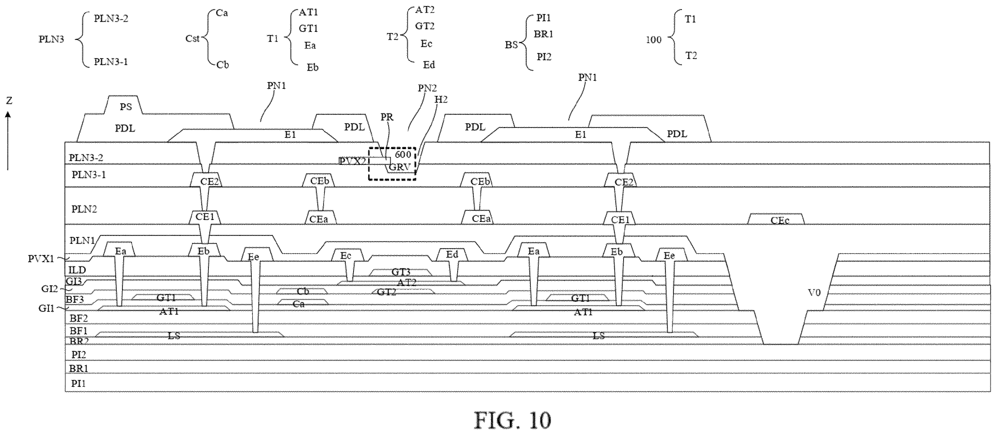

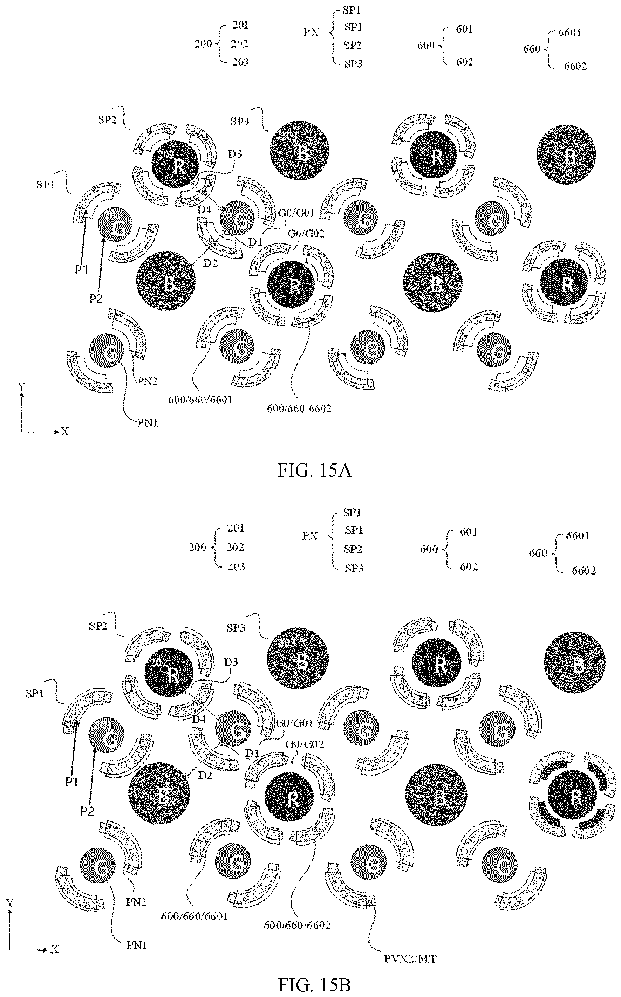

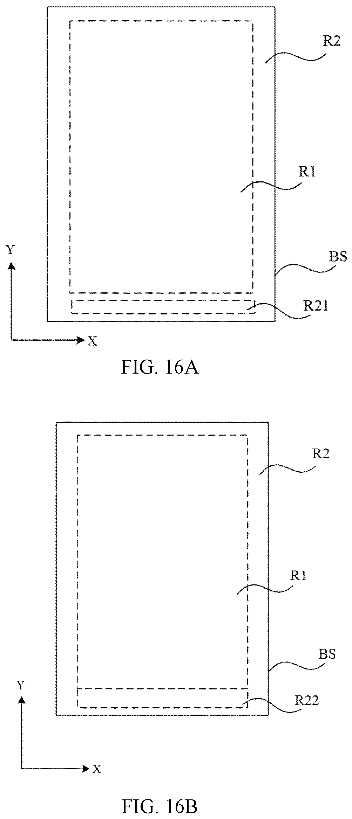

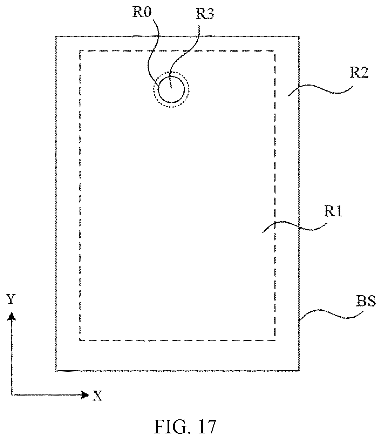

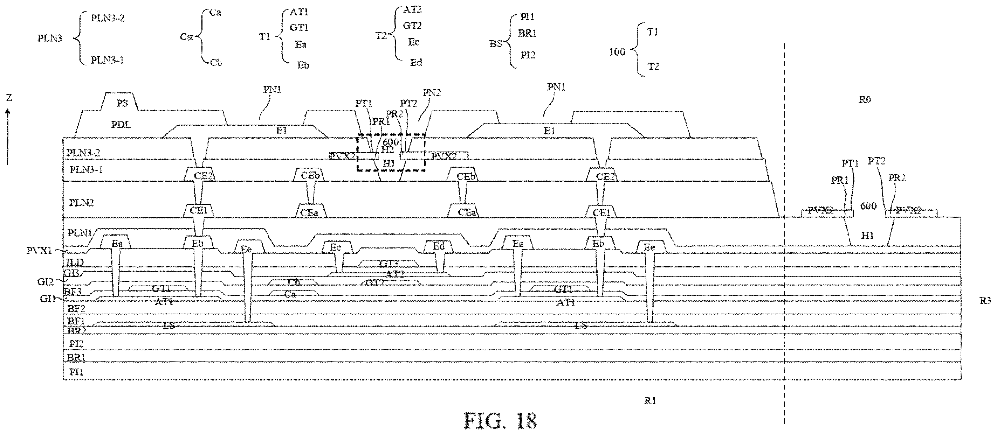

FIG. 5 is a cross-sectional view of a display panel provided by an embodiment of the present disclosure. FIG. 6 is a partial enlarged view of FIG. 5. FIG. 7 is a cross-sectional view of a display panel provided by an embodiment of the present disclosure. FIG. 8 is a partial enlarged view of FIG. 7. FIG. 9 is a plan view of a display panel provided by an embodiment of the present disclosure. FIG. 10 to FIG. 14 are cross-sectional views of several display panels provided by embodiments of the present disclosure. FIG. 15A is a plan view of a display panel provided by an embodiment of the present disclosure. FIG. 15B is a plan view of a display panel provided by an embodiment of the present disclosure. FIG. 16A is a schematic diagram illustrating region division of a display panel provided by an embodiment of the present disclosure. FIG. 16B is a schematic diagram illustrating region division of another display panel provided by an embodiment of the present disclosure. FIG. 17 is a schematic diagram illustrating region division of another display panel provided by an embodiment of the present disclosure. FIG. 18 to FIG. 21 are cross-sectional views of several display panels provided by embodiments of the present disclosure.

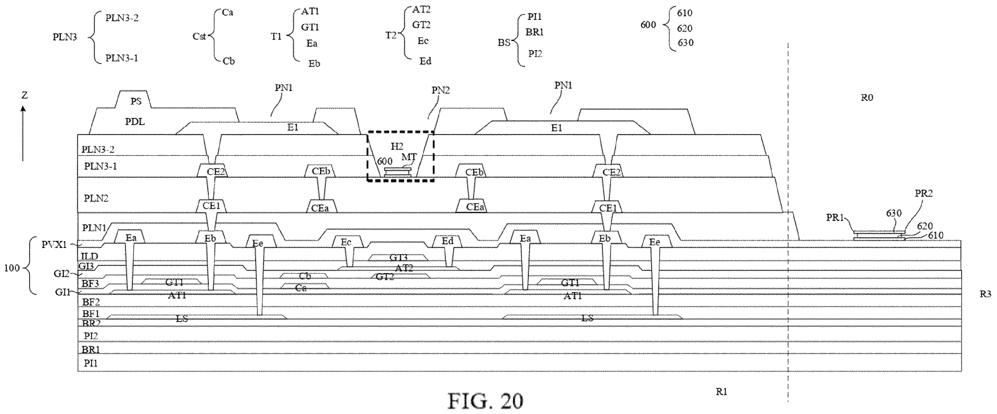

As shown in FIG. 5 to FIG. 8, FIG. 10 to FIG. 14, and FIG. 18 to FIG. 21, embodiments of the present disclosure provide a display panel including a base substrate BS, a plurality of pixel circuits 100, an insulating layer ISL, a plurality of pixel electrodes E1, a light-emitting functional layer EML, and a separation structure 600. The plurality of pixel circuits 100 are located on the base substrate BS. The insulating layer ISL is located at a side of the plurality of pixel circuits 100 facing away from the base substrate BS and includes a plurality of planarization layers, and each of the plurality of planarization layers includes an organic material. The pixel electrode E1 is located at a side of the plurality of planarization layers facing away from the base substrate BS and is connected to one pixel circuit 100 among the plurality of pixel circuits 100. The light-emitting functional layer EML includes a common layer CL; an orthographic projection of the common layer CL on the base substrate BS overlaps with orthographic projections of the plurality of pixel electrodes E1 on the base substrate BS; and at least part of the common layer CL is located at a side of the plurality of pixel electrodes E1 facing away from the base substrate BS. As shown in FIG. 5 to FIG. 8, FIG. 10 to FIG. 14, FIG. 18 to FIG. 19, and FIG. 21, the separation structure 600 has a protrusion PR protruding from the planarization layer below it; alternatively, as shown in FIG. 20, the separation structure 600 itself has a protrusion PR. As shown in FIG. 7 and FIG. 8, the separation structure 600 is configured to disconnect the common layer CL at the protrusion PR. As shown in FIG. 5 to FIG. 8, FIG. 10 to FIG. 14, and FIG. 18 to FIG. 21, the separation structure 600 is located between adjacent pixel electrodes E1, and includes an inorganic material. The separation structure 600 is located on at least part of the planarization layer, and the separation structure 600 is spaced apart from the plurality of pixel electrodes E1 by at least part of the planarization layer. For example, the separation structure 600 is spaced apart from the plurality of pixel electrodes E1 by at least part of the planarization layer, which means that at least part of one planarization layer is arranged between the separation structure 600 and the plurality of pixel electrodes E1. The cross-sectional views of the present disclosure show a planarization structure layer PLN composed of a plurality of planarization layers.

The display panel provided by the embodiments of the present disclosure has at least one of the following effects. Firstly, the separation structure 600 has a protrusion PR protruding from the planarization layer below it, or the separation structure 600 itself has a protrusion PR, and the pixel electrode E1 is spaced apart from the separation structure 600 by at least part of the planarization layer, thus ensuring the flatness, facilitating the planarization of the pixel electrode E1, improving the light efficiency and promoting the display effect. Secondly, the pixel electrode E1 is spaced apart from the separation structure 600 by at least part of the planarization layer, and the separation structure 600 is located below the pixel electrode E1, so even if there is a limit of small spacing between the pixel electrodes, a double-sided disconnection (two-sided disconnection) can still be carried out to improve the disconnecting effect. Thirdly, the pixel defining layer is not in direct contact with the structure forming the separation structure 600, thus avoiding the risk of peeling off of the pixel defining layer. Fourthly, the structure for forming the separation structure 600 can be made smaller, which is beneficial for an outgas of the planarization layer in an annealing process and reduces an outgas risk caused by a subsequent high-temperature process. Fifthly, the influence on the bending performance of the display panel can be reduced. Sixthly, the lateral crosstalk of adjacent sub-pixels is avoided. For example, the structure for forming the separation structure 600 includes a passivation layer PVX2 mentioned later.

For example, the common layer CL includes at least a charge generation layer, but the present disclosure is not limited thereto.

For example, as shown in FIG. 5 to FIG. 8, FIG. 10 to FIG. 14, FIG. 18 to FIG. 19, and FIG. 21, the separation structure 600 includes a passivation layer PVX2, which is provided for forming a protrusion PR. FIG. 20 shows the case where the separation structure 600 itself includes a protrusion PR.

For example, as shown in FIG. 5 to FIG. 8, FIG. 10 to FIG. 14, and FIG. 18 to FIG. 21, a plurality of planarization layers include a planarization layer PLN1, a planarization layer PLN2 and a planarization layer PLN3, which are sequentially arranged. The planarization layer PLN1 is closer to the base substrate BS than the planarization layer PLN3 to the base substrate BS; and the separation structure 600 is located above at least part of the planarization layer and below at least part of the planarization layer, in a direction perpendicular to the base substrate BS.

For example, the planarization layer PLN1 may be referred to as a first planarization layer, the planarization layer PLN2 may be referred to as a second planarization layer, and the planarization layer PLN3 may be referred to as a third planarization layer, but the present disclosure is not limited thereto.

It should be noted that in the embodiment of the present disclosure, the number of the planarization layers is not limited to that shown in the drawings, and the number of the planarization layers may be set as at least two. For example, the number of the planarization layers can also be set as three or more, depending on the layer structure of the display panel.

For example, as shown in FIG. 5 to FIG. 8, FIG. 10 to FIG. 12, FIG. 14, FIG. 19, and FIG. 21, the planarization layer located below the separation structure 600 has a groove GRV or a first through hole H1 at the protrusion PR. For example, the passivation layer PVX2 protrudes from the planarization layer located below it, at the groove GRV or the first through hole H1, to form the protrusion PR.

For example, in the embodiment of the present disclosure, a distance between the protrusion PR and a bottom surface of the groove GRV or the first through hole H1 is greater than or equal to 0.4µm, in order for better disconnecting effect.

For example, in the embodiment of the present disclosure, the distance between the protrusion PR and the bottom surface of the groove GRV or the first through hole H1 is greater than or equal to 0.4µm and less than or equal to 2µm, in order for better disconnecting effect.

For example, in the embodiment of the present disclosure, a protruding size of the protrusion PR in a lateral direction is greater than or equal to 0.1µm, in order for better disconnecting effect.

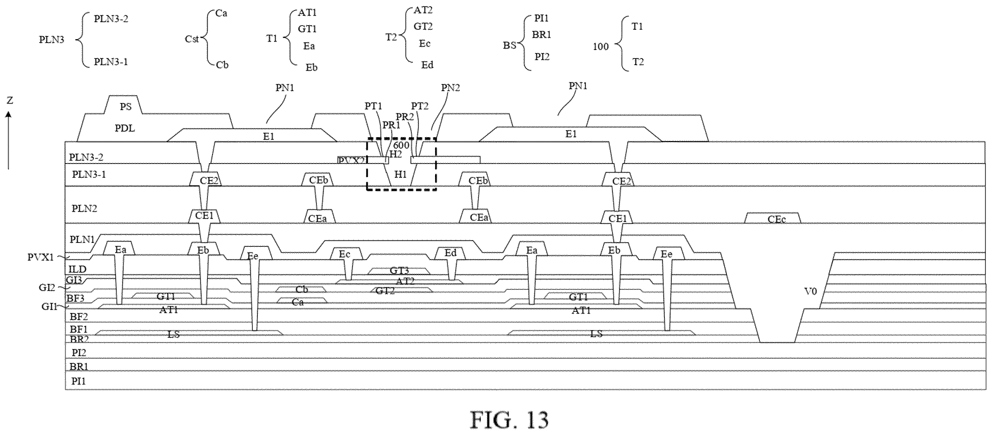

As shown in FIG. 5 to FIG. 8, FIG. 10 to FIG. 12, FIG. 14, FIG. 19 and FIG. 21, the planarization layer located below the separation structure 600 has a groove GRV at the protrusion PR. In FIG. 13 and FIG. 18, the planarization layer located below the separation structure 600 has a first through hole H1 at the protrusion PR. In the embodiment of the present disclosure, the groove GRV does not pass through the planarization layer located below the separation structure 600, and the first through hole H1 passes through the planarization layer located below the separation structure 600. As shown in FIG. 8, the groove GRV or the first through hole H1 is provided, so that part of the common layer CL is facilitated to be fallen into the groove GRV or the first through hole H1 during the subsequent formation of the common layer CL; in this way, the common layer CL is disconnected at the protrusion PR of the separation structure 600. FIG. 8 shows a separation part CL11 formed by disconnecting the first common layer CL1 at the separation structure 600 and a separation part CL21 formed by disconnecting the second common layer CL2 at the separation structure 600.

It should be noted that the form of at least one of the separation part CL11 or the separation part CL21 may be different from that shown in FIG. 8. For example, in some embodiments, at least one of the separation part CL11 or the separation part CL21 may also cover a sidewall of the groove GRV or the first through hole H1.

FIG. 7 and FIG. 8 illustrate the case where the electron transport layer ETL-2 and the common electrode E2 are continuous at the separation structure 600, by way of example. Embodiments of the present disclosure are not limited thereto. In some other embodiments, the electron transport layer ETL-2 and the common electrode E2 may also be disconnected at the separation structure 600. Whether the common electrode E2 is disconnected or not at the separation structure 600 may be related to a protruding size of the protrusion PR and/or a depth of the groove GRV or the first through hole H1 located below the protrusion PR. Of course, in some other embodiments, the display panel may not be provided with the electron transport layer ETL-2.

For example, as shown in FIG. 5 to FIG. 8, FIG. 10 to FIG. 12, FIG. 14, FIG. 19 and FIG. 21, the planarization layer located above the separation structure 600 has a second through hole H2 at the protrusion PR, and the first through hole H1 is communicated with the second through hole H2.

For example, as shown in FIG. 5 to FIG. 8, FIG. 10 to FIG. 12, FIG. 14, FIG. 19 and FIG. 21, a maximum size of the first through hole H1 is smaller than that of the second through hole H2.

For example, as shown in FIG. 9, FIG. 15A and FIG. 15B, the passivation layer PVX2 extends around the light-emitting region of the light-emitting element, and the maximum size of the first through hole H1 in a direction perpendicular to an extending direction of the passivation layer PVX2 is smaller than that of the second through hole H2 in the direction perpendicular to the extending direction of the passivation layer PVX2. That is, a maximum width of the first through hole H1 is smaller than that of the second through hole H2.

For example, as shown in FIG. 5 to FIG. 6, FIG. 10 to FIG. 12, FIG. 14, FIG. 19 and FIG. 21, the display panel further includes a pixel defining layer PDL having a plurality of first openings PN1, each of which is configured to expose one of a plurality of pixel electrodes E1. The pixel defining layer PDL also has a second opening PN2 communicated with the second through hole H2. The second opening PN2 is configured to expose the separation structure 600 to facilitate the common layer CL to be disconnected at the separation structure 600.

For example, as shown in FIG. 5 to FIG. 6, FIG. 10 to FIG. 12, FIG. 14, FIG. 19 and FIG. 21, an orthographic projection of the second opening PN2 on the base substrate BS overlaps with an orthographic projection of the separation structure 600 on the base substrate BS, so as to facilitate the second opening PN2 to expose the separation structure 600.

As shown in FIG. 5 to FIG. 8, FIG. 10 to FIG. 12, FIG. 14, FIG. 19 and FIG. 21, a main part of the pixel defining layer PDL is not in contact with the passivation layer PVX for forming the separation structure 600, so as to avoid the phenomenon that the pixel defining layer PDL is easily peeled off. The main part of the pixel defining layer PDL has a structure made of a material of the pixel defining layer.

For example, as shown in FIG. 10, the separation structure 600 has one protrusion PR at the groove GRV or the first through hole H1. That is, the separation structure 600 is formed as a single-sided structure, and a disconnection of the common layer CL is realized at the single side. In the case of single-sided disconnection (one-sided disconnection), occupied areas of the passivation layer PVX2 and the separation structure 600 can be reduced.

For example, as shown in FIG. 10, a thickness of the passivation layer PVX2 is about 0.07µm, and a width of the passivation layer PVX2 can be designed as about 3µm.

For example, in some other embodiments of the present disclosure, the thickness of the passivation layer PVX2 may also be set as about 0.07µm. Of course, the thickness of the passivation layer PVX2 is not limited to the above description.

For example, as shown in FIG. 5 to FIG. 6, FIG. 11 to FIG. 12, FIG. 14, FIG. 19 and FIG. 21, in order to improve the disconnecting effect, the separation structure 600 includes two separation parts, namely, a separation part PT1 and a separation part PT2, at the groove GRV or the first through hole H1, and these two separation parts form two protrusions PR, namely, a protrusion PR1 and a protrusion PR2, respectively. The protrusion PR1 is formed at the separation part PT1, and the protrusion PR2 is formed at the separation part PT2. Therefore, a double-sided structure is formed between two adjacent sub-pixels (two adjacent light-emitting elements), and a disconnection of the common layer CL is realized at both sides, which is more conducive to separating the common layer CL. As shown in FIG. 9, FIG. 15A, and FIG. 15B, the groove GRV or the first through hole H1 has an elongated shape. Combining part of cross-sectional views with the plan view shown in FIG. 9, the two protrusions PR are located in the groove GRV or the first through hole H1 and are located at two opposite sides of the elongated groove GRV or first through hole H1. One of the two protrusions PR is located closer to the light-emitting region of the light-emitting element than the other one to the light-emitting region. A shape of the second opening PN2 in the plan view is similar to that of the groove GRV or the first through hole H1, but a size of the groove GRV or the first through hole H1 may be slightly smaller than that of the second opening PN2.

Whether to form a single-sided separation structure or a double-sided separation structure can be determined according to a spacing distance between two adjacent light-emitting elements.

For example, as shown in FIG. 7 and FIG. 8, the display panel further includes a common electrode E2, at least part of the common electrode E2 is located at a side of the light-emitting functional layer EML facing away from the base substrate BS; and the plurality of pixel electrodes E1, the light-emitting functional layer EML, and the common electrode E2 constitute a plurality of light-emitting elements 200. FIG. 7 and FIG. 8 show a light-emitting element EM1 and a light-emitting element EM2. FIG. 9, FIG. 15A and FIG. 15B show a plurality of light-emitting elements 200.

FIG. 7 and FIG. 8 show the light-emitting functional layer EML and the common electrode E2; and for other display panels in the cross-sectional views not showing the light-emitting functional layer EML and the common electrode E2, reference can be made to FIG. 7.

For example, as shown in FIG. 5 to FIG. 8, FIG. 10 to FIG. 12, FIG. 14, FIG. 19 and FIG. 21, the passivation layer PVX2 for forming the separation structure 600 protrudes laterally from the planarization layer located below it and protrudes laterally from the planarization layer located above it. For example, a lateral direction refers to the direction parallel to the main surface of the base substrate.

For example, as shown in FIG. 5 to FIG. 8, FIG. 10 to FIG. 12, FIG. 14, FIG. 19 and FIG. 21, in order to facilitate the formation of the separation structure 600, a part of a lower surface of the passivation layer PVX2 is in contact with an upper surface of the planarization layer located below the passivation layer PVX2, and a part of the lower surface of the passivation layer PVX2 is not in contact with the upper surface of the planarization layer located below the passivation layer PVX2.

For example, as shown in FIG. 5 to FIG. 8, FIG. 10 to FIG. 12, FIG. 14, FIG. 19 and FIG. 21, in order to facilitate the formation of the separation structure 600, a part of the upper surface of the passivation layer PVX2 is in contact with a lower surface of the planarization layer located above the passivation layer PVX2, and a part of the upper surface of the passivation layer PVX2 is not in contact with the lower surface of the planarization layer located above the passivation layer PVX2.

For example, in some embodiments, at least part of a side surface of the protrusion PR of the passivation layer PVX2 is covered with a material of the light-emitting functional layer EML. For example, at least part of the side surface of the protrusion PR of the passivation layer PVX2 is covered with a material of at least one of the common layer CL or the local layer LL. For example, at least part of the side surface of the protrusion PR of the passivation layer PVX2 is covered with the common layer CL. In an embodiment of the present disclosure, the protrusion PR has a lower surface, an upper surface, and a side surface located between the lower surface and the upper surface. The lower surface of the protrusion PR is closer to the base substrate than the upper surface to the base substrate.

In the case where at least part of the side surface of the protrusion PR of the passivation layer PVX2 is covered with the material of the light-emitting functional layer EML, the protrusion PR can also function for disconnecting at least one film layer in the common layer CL.

It should be noted that for the sake of clear illustration, the material of the light-emitting functional layer EML on the side surface of the protrusion PR of the passivation layer PVX2 is not shown in FIG. 7 and FIG. 8.

For example, as shown in FIG. 9, FIG. 15A and FIG. 15B, the light-emitting element 200 includes a first light-emitting element 201, a second light-emitting element 202 and a third light-emitting element 203. The sub-pixel SP1 includes a first light-emitting element 201 and a pixel circuit (not shown in FIG. 9, FIG. 15A and FIG. 15B) connected to the first light-emitting element 201. The sub-pixel SP2 includes a second light-emitting element 202 and a pixel circuit (not shown in FIG. 9, FIG. 15A and FIG. 15B) connected to the second light-emitting element 202. The sub-pixel SP3 includes a third light-emitting element 203 and a pixel circuit (not shown in FIG. 9, FIG. 15A and FIG. 15B) connected to the third light-emitting element 203.

For example, as shown in FIG. 9, FIG. 15A and FIG. 15B, the separation structure 600 surrounding one light-emitting element 200 includes a plurality of separation substructures 660. As shown in FIG. 9, FIG. 15A and FIG. 15B, the separation structure 600 surrounding the light-emitting element 201 includes two separation substructures 660. As shown in FIG. 9, FIG. 15A and FIG. 15B, the separation structure 600 surrounding the light-emitting element 202 includes four separation substructures 660.

For example, as shown in FIG. 9, FIG. 15A and FIG. 15B, the plurality of separation substructures 660 at least include two separation substructures 660 located at two opposite sides of the light-emitting region (the position P2 indicates an outer edge of the light-emitting region, corresponding to the first opening PN1) of the light-emitting element 200. This arrangement facilitates the formation of a gap G0 between adjacent separation substructures 660. The arrangement of the gap G0 is beneficial for the continuity of the common electrode E2 and the application of signals on the common electrode E2. That is, it's conductive to the common electrode E2 corresponding to adjacent light-emitting elements to be formed into an integrated structure, which is beneficial for the application of signals. That is, the common electrode E2 can be disconnected at the separation structure 600 and connected at the gap G0, thus ensuring the continuity of the common electrodes E2 for different light-emitting elements. Of course, it is also possible to arrange a full circle of separation structure, that is, the separation structure surrounds the light-emitting region for a full circle. In this case, the common electrodes E2 corresponding to different sub-pixels can be connected through other film layers.

For example, as shown in FIG. 7 and FIG. 8, the common electrode E2 is not disconnected at the separation structure 600. Of course, the embodiments of the present disclosure are not limited to this. The common electrode E2 may also be disconnected at the separation structure 600. The common electrode E2 may be continuous at the gap G0 between the separation substructures 660 mentioned later. Of course, in the case where the common electrodes E2 of different sub-pixels are not integrated, the connection of the common electrodes E2 corresponding to different sub-pixels can also be realized through other film layers.

For example, as shown in FIG. 9, FIG. 15A and FIG. 15B, spacing distances between at least one separation substructure 660 among a plurality of separation substructures 660 and two light-emitting elements 200 adjacent thereto are not equal to each other. As shown in FIG. 9, FIG. 15A and FIG. 15B, for the light-emitting element 201 and the light-emitting element 203 adjacent thereto, the spacing distance D1 is smaller than the spacing distance D2. As shown in FIG. 9, FIG. 15A and FIG. 15B, for the light-emitting element 201 and the light-emitting element 202 adjacent thereto, the spacing distance D3 is smaller than the spacing distance D4. A separation structure 600 (separation substructure 660) between adjacent light-emitting elements is arranged closer to one of the adjacent light-emitting elements. In the case where two protrusions PR are arranged in one and the same second opening PN2, a center connecting line of the two protrusions PR can be used as one end for calculating the spacing distance.

As shown in FIG. 9, the position P1 is the position where one protrusion of the separation structure 600 is located, the position P4 is the position where another protrusion of the separation structure 600 is located, and the position P2 indicates an outer edge of the light-emitting region of the light-emitting element of the sub-pixel, corresponding to an edge of the first opening PN1. The plan view shown in FIG. 9 corresponds to the case where one separation structure 600 has two protrusions PR, and a double-sided disconnection is carried out. For example, FIG. 9 may be a plan view of the display panel shown in FIG. 5, FIG. 7, FIG. 11 to FIG. 13, FIG. 18, FIG. 19, or FIG. 21.

The display panel shown in FIG. 15A adopts a single-sided disconnection, which may be a plan view of the display panel shown in FIG. 10.

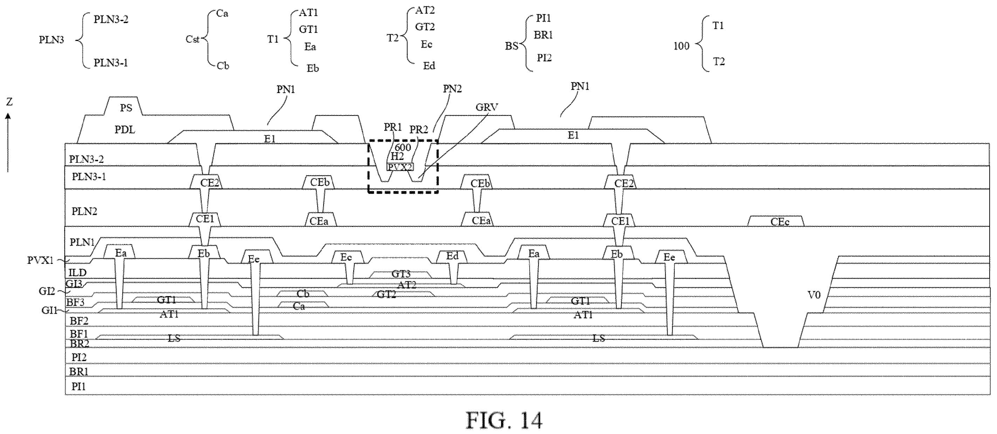

The display panel shown in FIG. 15B adopts a double-sided disconnection, and both ends of the passivation layer PVX2 or a metal structure MT perpendicular to an extending direction thereof can be located in the groove GRV (the groove can also be replaced by a through hole). FIG. 15B may be a plan view of the display panel shown in FIG. 14 or FIG. 20.

As shown in FIG. 5, FIG. 7, FIG. 11 to FIG. 14, and FIG. 18 to FIG. 20, both of the two protrusions PR are located in one and the same second opening PN2.

In the plan views shown in FIG. 9, FIG. 15A and FIG. 15B, a first opening PN1 and a second opening PN2 are shown, and the pixel defining layer PDL is shown as an opening in these plan views. In the pixel defining layer PDL, the remaining part except the first opening PN1 and the second opening PN2 is referred to as the main part.

As shown in FIG. 15A and FIG. 15B, the position P2 indicates the outer edge of the light-emitting region of the light-emitting element of the sub-pixel, corresponding to the edge of the first opening PN1; and the position P1 is the position where the separation structure 600 (the protrusion of the separation structure 600) is located.

For example, as shown in FIG. 9, FIG. 15A and FIG. 15B, the light-emitting region of the first light-emitting element 201 is smaller than that of the second light-emitting element 202, and the light-emitting region of the second light-emitting element 202 is smaller than that of the third light-emitting element 203. The separation structure 600 includes a first separation structure 601 and a second separation structure 602, which are located at a periphery of the light-emitting region of the first light-emitting element 201 and a periphery of the light-emitting region of the second separation structure 602, respectively.

For example, as shown in FIG. 9, FIG. 15A and FIG. 15B, the first separation structure 601 includes two first separation substructures 6601 located at two opposite sides of the light-emitting region of the first light-emitting element 201; and the second separation structure 602 includes four second separation substructures 6602, which are arranged around the light-emitting region of the second light-emitting element 202. Two second separation substructures 6602 of the four second separation substructures 6602 are located at two opposite sides of the light-emitting region of the second light-emitting element 202, and the other two second separation substructures 6602 of the four second separation substructures 6602 are located at two opposite sides of the light-emitting region of the second light-emitting element 202. As shown in FIG. 9, the four second separation substructures 6602 are sequentially arranged around the light-emitting region of the second light-emitting element 202. As shown in FIG. 9, there is a gap G01 between two first separation substructures 6601. As shown in FIG. 9, FIG. 15A and FIG. 15B, there is a gap G02 between two adjacent second separation substructures 6602. A size of the gap G01 is larger than that of the gap G02.

For example, as shown in FIG. 9, FIG. 15A and FIG. 15B, the light-emitting region of the first light-emitting element 201 is surrounded by two first separation substructures 6601 and two second separation substructures 6602 located at the gap of the first separation substructures 6601. Therefore, the separation structure 600/separation substructure 660 is provided in regions between the first light-emitting element 201 and two second light-emitting elements 202 adjacent thereto, and between the first light-emitting element 201 and two third light-emitting elements 203 adjacent thereto, which is beneficial to reducing or avoiding the crosstalk between adjacent sub-pixels.

For example, as shown in FIG. 9, FIG. 15A and FIG. 15B, the light-emitting region of the third light-emitting element 203 is surrounded by four first separation substructures 6601 and two second separation substructures 6602. Therefore, the separation structure 600/separation substructure 660 is provided in regions between the third light-emitting element 203 and two second light-emitting elements 202 adjacent thereto, and between the third light-emitting element 203 and four first light-emitting elements 201 adjacent thereto, which is beneficial to reducing or avoiding the crosstalk between adjacent sub-pixels.

For example, as shown in FIG. 9, FIG. 15A and FIG. 15B, the first light-emitting element 201 is configured to emit green light, the second light-emitting element 202 is configured to emit red light, and the third light-emitting element 203 is configured to emit blue light. FIG. 9 illustrates the case where the first light-emitting element 201 is configured to emit green light, the second light-emitting element 202 is configured to emit red light and the third light-emitting element 203 is configured to emit blue light by way of example. However, the light-emitting colors of the light-emitting elements given by the embodiments of the present disclosure are not limited to this, and may be determined as required.

For example, as shown in FIG. 9, FIG. 15A and FIG. 15B, the repeating unit PX includes two first sub-pixels SP1, one second sub-pixel SP2 and one third sub-pixel SP3. For example, as shown in FIG. 9, in one repeating unit PX, the second sub-pixel SP2 and the third sub-pixel SP3 are respectively arranged at both sides of a center connecting line of the two first sub-pixels SP1. Of course, the pixel arrangement of the display panel is not limited to that shown in FIG. 9, but can be configured as required.

As shown in FIG. 9, FIG. 15A and FIG. 15B, a distance from a separation substructure 660 arranged around a light-emitting region of one light-emitting element to the light-emitting region of the light-emitting element is greater than a distance from the separation substructure 660 to a light-emitting region of another light-emitting element adjacent to the light-emitting element. That is, the separation substructure 660 is closer to the light-emitting region of the light-emitting element surrounded by the separation substructure 660.

FIG. 9, FIG. 15A and FIG. 15B illustrate an example in which a plurality of passivation layers PVX2 are provided around the light-emitting region of the light-emitting element to form the separation structure 600, but the present disclosure is not limited to this. The passivation layer PVX2 arranged around the light-emitting region of the light-emitting element can also be provided in a full-circle structure, as long as a plurality of discrete second openings PN2 are arranged around the light-emitting region of one and the same light-emitting element. For a plurality of separation substructures provided for the light-emitting region of one and the same light-emitting element, the position between adjacent second openings PN2 corresponds to a gap G0. That is, in the embodiment of the present disclosure, in order to facilitate the continuity of the common electrodes E2, a plurality of second openings PN2 are arranged around the light-emitting region of one and the same light-emitting element, and the region between adjacent second openings PN2 is a gap G0.

FIG. 9, FIG. 15A and FIG. 15B illustrate an example in which the separation structure 600/separation substructure 660 is in an arc shape. However, the present disclosure is not limited to this, and can be configured as required. For example, the separation structure 600/separation substructure 660 may be configured according to the shape of the outer edge of the light-emitting region of the light-emitting element.

FIG. 9, FIG. 15A and FIG. 15B illustrate an example in which the light-emitting region of the sub-pixel/light-emitting element has a circular shape, but the present disclosure is not limited to this. The light-emitting region of the sub-pixel/light-emitting element can be configured as other shapes as required, for example, it can be configured as a pentagonal shape, a hexagonal shape, a rectangular shape and other shapes.

For example, as shown in FIG. 5 to FIG. 8, FIG. 10 to FIG. 14 and FIG. 18 to FIG. 21, the separation structure 600 is not in contact with the plurality of pixel electrodes E1. Therefore, the separation structure 600 is prevented from affecting the flatness of the pixel electrode E1 and the display effect.

For example, as shown in FIG. 5 to FIG. 8, FIG. 10 to FIG. 14, FIG. 18 to FIG. 19, and FIG. 21, the inorganic material included in the separation structure 600 includes an inorganic nonmetallic material, and the inorganic material is an insulating material. The separation structure 600 includes a passivation layer PVX2, and the passivation layer PVX2 protrudes from a planarization layer below it, thereby forming a protrusion PR. The passivation layer PVX2 includes an inorganic nonmetallic material, and the inorganic material is an insulating material. For example, the material of the passivation layer PVX2 includes at least one of silicon oxide, silicon nitride and silicon oxynitride.

For example, as shown in FIG. 20, the separation structure 600 includes a metal structure MT, and the inorganic material included in the separation structure 600 includes a metal material, or the metal structure MT includes a metal material. The separation structure 600/metal structure MT includes a first sublayer 610, a second sublayer 620, and a third sublayer 630 which are stacked and arranged in sequence. The first sublayer 610 is closer to the base substrate BS than the third sublayer 630 to the base substrate BS, and the third sublayer 630 protrudes outwardly relative to the second sublayer 620 to form the protrusion PR. For example, materials of the first sublayer 610, the second sublayer 620, and the third sublayer 630 include metals, respectively. For example, the materials of the first sublayer 610 and the third sublayer 630 are the same as each other, and are different from that of the second sublayer 620. For example, the materials of the first sublayer 610 and the third sublayer 630 include titanium. For example, the material of the second sublayer 620 includes aluminum. For example, the first sublayer 610, the second sublayer 620, and the third sublayer 630 form a structure in which three sublayers of Ti/Al/Ti are stacked. For example, as shown in FIG. 20, the second sublayer 620 is retracted inwardly relative to the first sublayer 610 and the third sublayer 630.

For example, as shown in FIG. 5 to FIG. 8, FIG. 10 to FIG. 14 and FIG. 18 to FIG. 21, the display panel further includes a first connection electrode CE1 and a second connection electrode CE2; the pixel circuit 100 includes a transistor T1; the first connection electrode CE1 is located on the planarization layer PLN1 and is connected to the transistor T1 through a via hole passing through the planarization layer PLN1; the second connection electrode CE2 is located on the planarization layer PLN2 and is connected to the first connection electrode CE1 through a via hole passing through the planarization layer PLN2; and the pixel electrode E1 is located on the planarization layer PLN3 and is connected to the second connection electrode CE2 through a via hole passing through the planarization layer PLN3.

For example, as shown in FIG. 5 to FIG. 8, FIG. 10 to FIG. 14 and FIG. 18 to FIG. 21, the transistor T1 includes a gate electrode GT1, a gate insulating layer GI1, an active layer AT1, a first electrode Ea, and a second electrode Eb; the first electrode Ea and the second electrode Eb are connected to both ends of the active layer AT1, respectively. The first connection electrode CE1 is connected to the second electrode Eb. For example, the active layer AT1 of the transistor T1 adopts a low-temperature polysilicon (LTPS), but the present disclosure is not limited to this.

For example, as shown in FIG. 5 to FIG. 8, FIG. 10 to FIG. 14 and FIG. 18 to FIG. 21, the pixel circuit 100 further includes a transistor T2, which includes a gate electrode GT2, a gate electrode GT3, a gate insulating layer GI2, a gate insulating layer GI3, an active layer AT2, a first electrode Ec, and a second electrode Ed; and the first electrode Ec and the second electrode Ed are connected to both ends of the active layer AT2, respectively. For example, the gate electrode GT2 and the gate electrode GT3 of the transistor T2 form a double-gate structure to improve the performance of the transistor T2. For example, the active layer AT2 of the transistor T2 adopts an oxide semiconductor, such as indium gallium zinc oxide (IGZO), but the present disclosure is not limited to this.

For example, as shown in FIG. 5 to FIG. 8, FIG. 10 to FIG. 14 and FIG. 18 to FIG. 21, the insulating layer ISL further includes an inorganic insulating layer PVX1, which is located between the pixel circuit 100 (including the transistor T1 and the transistor T2) and the planarization layer PLN1; and the first connection electrode CE1 also passes through the inorganic insulating layer PVX1.

For example, as shown in FIG. 5 to FIG. 8, FIG. 10 to FIG. 14, and FIG. 18 to FIG. 21, the inorganic insulating layer PVX1 is arranged at a side of the planarization layer close to the base substrate BS.

For example, as shown in FIG. 5 to FIG. 8, FIG. 10 to FIG. 14 and FIG. 18 to FIG. 21, the pixel electrode E1 is connected to one of a plurality of pixel circuits 100 through a via hole passing through at least part of the insulating layer ISL. In the case where a connection electrode is provided, the pixel electrode E1 is connected to the connection electrode through a via hole passing through at least part of the insulating layer ISL, and the connection electrode is then connected to the pixel circuit 100. In the case where the connection electrode is not provided, the pixel electrode E1 is connected to the pixel circuit 100 through a via hole passing through the insulating layer ISL.

For example, as shown in FIG. 5 to FIG. 8, FIG. 10 to FIG. 14 and FIG. 18 to FIG. 21, the base substrate BS includes a first base substrate PI1, a barrier layer BR1, and a second base substrate PI2. Of course, the structure of the base substrate BS is not limited to the above description. For example, the base substrate BS may also adopt a single-layered structure.

For example, the base substrate BS may be a flexible base substrate, but the present disclosure is not limited thereto. By using a flexible base substrate, it's beneficial for bending and hence reducing the bezel, or beneficial to forming a foldable display panel.

As shown in FIG. 5 to FIG. 8, FIG. 10 to FIG. 14, and FIG. 18 to FIG. 21, the barrier layer BR2 is located on the base substrate BS, and a light shielding layer LS is provided on the barrier layer BR2, a buffer layer BF1 is provided on the light shielding layer LS, a buffer layer BF2 is provided on the buffer layer BF1, an active layer AT2 is provided on the buffer layer BF2, a gate insulating layer GI1 is provided on the active layer AT2, a gate electrode GT1 is located on the gate insulating layer GI1, a buffer layer BF3 is provided on the gate electrode GT1, a gate electrode GT2 is provided on the buffer layer BF3, a gate insulating layer GI2 is provided on the gate electrode GT2, an active layer AT2 is provided on the gate insulating layer GI2, a gate insulating layer GI3 is provided on the active layer AT2, an interlayer insulating layer ILD is provided on the gate insulating layer GI3; and a first electrode Ea, a second electrode Eb, a first electrode Ec and a second electrode Ed are provided on the interlayer insulating layer ILD. The light shielding layer LS can block light so as to improve the performance of the transistor T1.

For example, the barrier layer BR2 and the barrier layer BR1 may use the same material, but the present disclosure is not limited thereto.

As shown in FIG. 5 to FIG. 8, FIG. 10 to FIG. 14, and FIG. 18 to FIG. 21, the display panel further includes a connection electrode Ee which can be connected with the light shielding layer LS. The connection electrode Ee may be connected to other signal lines, such as a power supply line providing a constant voltage, to reduce the resistance of the power supply line. For example, the power supply line may be a signal line providing a power supply voltage VDD. The connection electrode Ee is located on the interlayer insulating layer ILD, and can be arranged at the same layer as the first electrode Ea, the second electrode Eb, the first electrode Ec, and the second electrode Ed.

As shown in FIG. 5 to FIG. 8, FIG. 10 to FIG. 14, and FIG. 18 to FIG. 21, the display panel further includes a connection electrode CEa and a connection electrode CEb which are connected to each other; the connection electrode CEa is located on the planarization layer PLN1; the connection electrode CEb is located on the planarization layer PLN2, and the connection electrode CEb is connected to the connection electrode CEa through a via hole passing through the planarization layer PLN2. The connection electrode CEa and the connection electrode CE1 are located at the same layer; and the connection electrode CEb and the connection electrode CE2 are located at the same layer.

As shown in FIG. 5 to FIG. 8, FIG. 10 to FIG. 14 and FIG. 18 to FIG. 21, the display panel further includes a storage capacitor Cst including a first electrode plate Ca and a second electrode plate Cb. For example, the first electrode plate Ca and the gate electrode GT1 are located at the same layer; and the second electrode plate Cb and the gate electrode GT2 are located at the same layer.

As shown in FIG. 5 to FIG. 8, FIG. 10 to FIG. 14 and FIG. 18 to FIG. 21, the display panel further includes a spacer PS configured to support a fine metal mask during an evaporation of the local layer LL in the light-emitting functional layer EML.

For example, the spacer PS can be integrated with the pixel defining layer PDL, and can be made by using a dual-tone mask.

For example, as shown in FIG. 5 to FIG. 8, FIG. 10 to FIG. 14 and FIG. 18 to FIG. 21, in order to facilitate the planarization of the pixel electrode E1, the planarization layer PLN3 includes a planarization sublayer PLN3-1 and a planarization sublayer PLN3-2. The planarization sublayer PLN3-1 is closer to the base substrate BS than the planarization sublayer PLN3-2 to the base substrate BS. Of course, in some other embodiments, the planarization layer PLN3 can also adopt a single-layered structure.

As shown in FIG. 5, FIG. 7, FIG. 10, FIG. 19 and FIG. 21, the passivation layer PVX2 is arranged on the planarization sublayer PLN3-1 (a part of the planarization layer PLN3); and the passivation layer PVX2 is spaced apart from the pixel electrode E1 by the planarization sublayer PLN3-2 (a part of the planarization layer PLN3). In FIG. 5, a groove GRV is formed in the planarization sublayer PLN3-1.

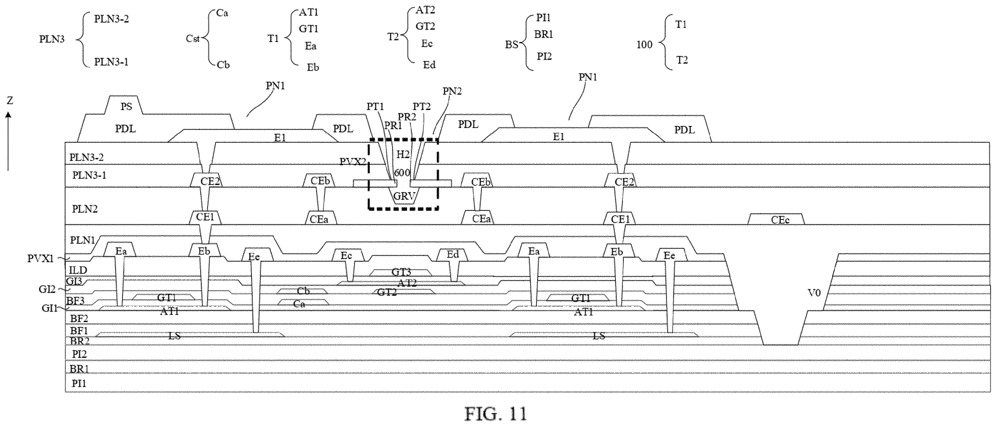

As shown in FIG. 11, the passivation layer PVX2 is arranged on the planarization layer PLN2 (a part of the planarization layer); and the passivation layer PVX2 is spaced apart from the pixel electrode E1 by the planarization layer PLN3 (a part of the planarization layer). In FIG. 11, a groove GRV is formed in the planarization layer PLN2.

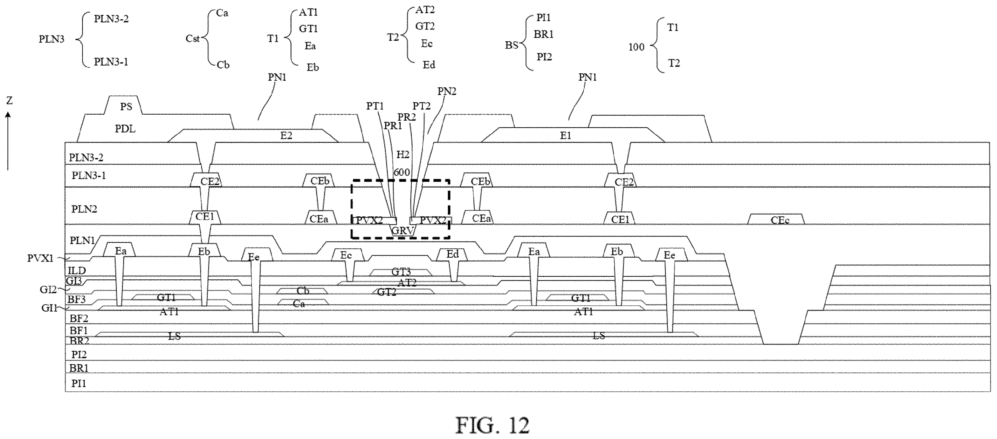

As shown in FIG. 12, the passivation layer PVX2 is arranged on the planarization layer PLN1 (a part of the planarization layer); and the passivation layer PVX2 is spaced apart from the pixel electrode E1 by the planarization layer PLN2 and the planarization layer PLN3 (a part of the planarization layer). In FIG. 12, a groove GRV is formed in the planarization layer PLN1.

FIG. 10 to FIG. 12 show the cases where the separation structure 600 is moved downwardly to form display panels with different structures. It should be noted that the separation structure 600 can be arranged above the planarization layer PLN1 and can be located at any position of film layer spaced apart from the pixel electrode E1 by at least part of the planarization layer.

As shown in FIG. 13 and FIG. 18, the passivation layer PVX2 is arranged on the planarization sublayer PLN3-1 (a part of the planarization layer PLN3); and the passivation layer PVX2 is spaced apart from the pixel electrode E1 by the planarization sublayer PLN3-2 (a part of the planarization layer PLN3). In FIG. 13, a first through hole H1 is formed in the planarization sublayer PLN3-1.

As shown in FIG. 14, the passivation layer PVX2 is arranged on the planarization sublayer PLN3-1 (a part of the planarization layer PLN3); and the passivation layer PVX2 is spaced apart from the pixel electrode E1 by the planarization sublayer PLN3-2 (a part of the planarization layer PLN3). In FIG. 14, a groove GRV is formed in the planarization sublayer PLN3-1. Of course, the groove GRV shown in FIG. 14 can also be a through hole, which can at least pass through the planarization sublayer PLN3-1. For example, the through hole may pass through the planarization sublayer PLN3-1 and the planarization layer PLN2; alternatively, the through hole may not pass through the planarization layer PLN2, but be in the form of a groove in the planarization layer PLN2. In the embodiments of the present disclosure, any structure can be referred to as a through hole as long as it passes through one layer.

For example, as shown in FIG. 14, the passivation layer PVX2 is located between two adjacent sub-pixels. For example, the passivation layer PVX2 is located in the middle between two adjacent sub-pixels, and a width of the passivation layer PVX2 can be designed as about 5µm, so that a double-sided disconnection can be realized to enhance the disconnecting effect.

As shown in FIG. 20, the passivation layer PVX2 is arranged on the planarization layer PLN2 (a part of the planarization layer); and the passivation layer PVX2 is spaced apart from the pixel electrode E1 by the planarization layer PLN3 (a part of the planarization layer). In FIG. 14, a first through hole H1 is formed in the planarization layer PLN2.

As shown in FIG. 16A, the display panel includes a display region R1 and a peripheral region R2 which may surround the display region R1. The peripheral region R2 has a bending region R21, so that a part of the display panel can be bent to the back side to reduce the bezel of the display panel.

For example, as shown in FIG. 5 and FIG. 16A, the display panel has a bending region R21, and a via hole V0 can be provided in the bending region R21, so that a planarization layer can be filled in the via hole V0 to enhance the bending performance of the display panel.

As shown in FIG. 5 to FIG. 8 and FIG. 10 to FIG. 14, the via hole V0 passes through the passivation layer PVX1, the interlayer insulating layer ILD, the gate insulating layer GI3, the gate insulating layer GI2, the buffer layer BF3, the gate insulating layer GI1, the buffer layer BF2, the buffer layer BF1, and the barrier layer BR2.

As shown in FIG. 5 to FIG. 8 and FIG. 10 to FIG. 14, the connection electrode CEc is located in the bending region R21. The connection electrode CEc overlaps with the via hole V0. For example, the connection electrode CEc may be connected to a signal line located in the display region, such as a data line or a power supply line providing a constant voltage. For example, the power supply line providing a constant voltage includes a power supply line providing a constant voltage VDD and a power supply line providing a constant voltage VSS. Of course, the connection electrode CEc may also be connected to other signal lines. The embodiments of the present disclosure are not intended to limit the signal line to which the connection electrode CEc is connected.

As shown in FIG. 16B, the display panel includes a display region R1 and a peripheral region R2 which may surround the display region R1. The peripheral region R2 has a wiring connection region R22. For example, the wiring connection region R22 can be connected to an integrated circuit or a flexible circuit board, but the present disclosure is not limited to this. The display panel may not be provided with a bending region if the display panel has no need of bending.

As shown in FIG. 17, the display panel includes a display region R1 and a peripheral region R2 which may surround the display region R1.

For example, as shown in FIG. 17, the display panel has a hole region R3 and is provided with a plurality of separation structures 600, and at least part of the separation structures 600 are located in a bezel region R0 close to the hole region R3. The bezel region R0 is used for wirings to be arranged therein. At least part of the display panel located in the hole region R3 is removed to form a receiving cavity, and a sensor can be arranged in the receiving cavity. For example, the sensor includes a camera, but the present disclosure is not limited thereto.

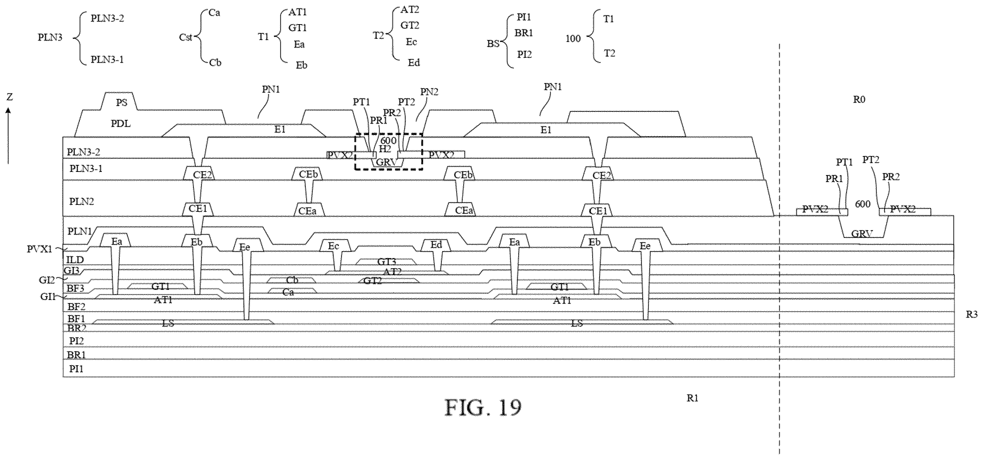

In the bezel region R0 shown in FIG. 18 and FIG. 19, at the separation structure 600, the passivation layer PVX2 is located on the planarization layer PLN1. However, the planarization layer here is not limited to the planarization layer PLN1, and other planarization layers can also be used.

As shown in FIG. 18 and FIG. 19, the separation structure 600 located in the display region R1 and the separation structure 600 located in the bezel region R0 can be fabricated by using the same patterning process.

As shown in FIG. 18 and FIG. 19, the separation structure 600 located in the display region R1 and the separation structure 600 located in the bezel region R0 have the same structure.

FIG. 18 to FIG. 21 show a display region R1, a bezel region R0, and a hole region R3. In the display panel shown in FIG. 18 to FIG. 21, the structure at the hole region R3 is completely removed.

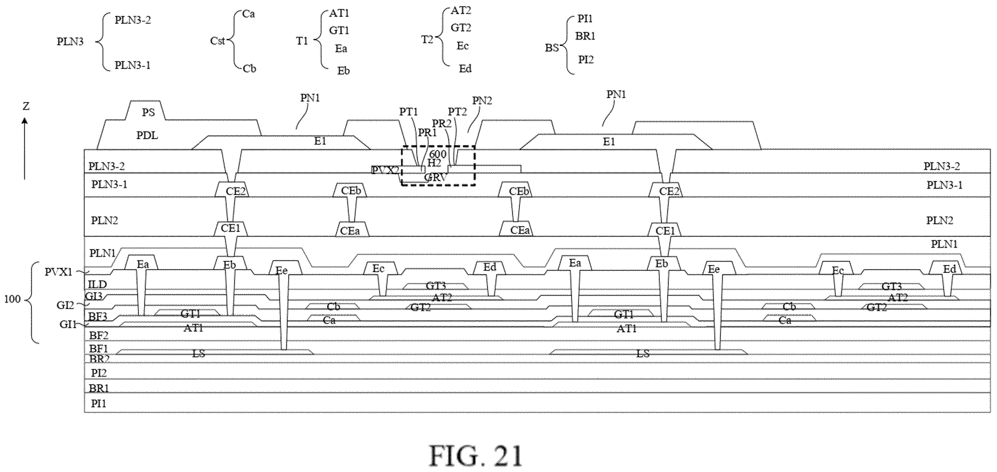

FIG. 21 shows a separation structure 600 arranged between adjacent sub-pixels in the display region. The display panels shown in FIG. 5, FIG. 7, and FIG. 10 to FIG. 14 may not be provided with a bending region, thereby forming a structure similar to that shown in FIG. 21.

For example, in some embodiments, the passivation layer PXV2 for forming the separation structure 600 is only located in the display region R1. Of course, in the display panel having a bezel region R0, the passivation layer PXV2 for forming the separation structure 600 may be located in the display region R1 and the bezel region R0.

In some embodiments, the display panel may have a bending region R21 and a hole region R3.

For example, in an embodiment of the present disclosure, components located at the same layer may be formed from the same film layer by using the same patterning process. In the embodiments of the present disclosure, the patterning or patterning process may include only a photolithography process, or may include a photolithography process and an etching step, or may include printing, inkjet and other processes for forming a predetermined pattern. A photolithography process refers to a process which includes film formation, exposure, development and other processing steps, and forms a pattern by using photoresist, mask plate, exposure machine and the like. A corresponding patterning process can be selected according to the structure formed in the embodiment of the present disclosure.

For example, in the embodiment of the present disclosure, in the case where the planarization layer PLN3 includes a planarization sublayer PLN3-1 and a planarization sublayer PLN3-2, a thickness of the planarization sublayer PLN3-1 may be 1-2µm, and a thickness of the planarization sublayer PLN3-2 may be 1-2µm. For example, in this case, the thickness of the planarization layer PLN3 may be 2-4µm.

For example, in the embodiment of the present disclosure, in the case where the planarization layer PLN3 has a single-layered structure, the thickness of the planarization layer PLN3 may be 1-2µm.

For example, in the embodiment of the present disclosure, the thickness of the planarization layer PLN1 may be 1-2µm.

For example, in the embodiment of the present disclosure, the thickness of the planarization layer PLN2 may be 1-2µm.

For example, in the embodiment of the present disclosure, the thickness of the passivation layer PVX1 may be 0.1-0.25µm.

For example, in the embodiment of the present disclosure, the base substrate BS, the buffer layer BF1, the buffer layer BF2, the buffer layer BF3, the gate insulating layer GI1, the gate insulating layer GI2, the gate insulating layer GI3, the interlayer insulating layer ILD, the passivation layer PVX1, the passivation layer PVX2, the planarization layer PLN1, the planarization layer PLN2, the planarization layer PLN3 and the pixel defining layer PDL are all made of insulating materials.

For example, the material of the base substrate BS includes polyimide, but the present disclosure is not limited to this. For example, the material of the base substrate PI1 includes polyimide, but the present disclosure is not limited thereto. For example, the material of the base substrate PI2 includes polyimide, but the present disclosure is not limited thereto. For example, the base substrate BS may be a flexible base substrate, and hence a flexible display panel can be obtained.

For example, the material of at least one of the buffer layer BF1, the buffer layer BF2, the buffer layer BF3, the gate insulating layer GI1, the gate insulating layer GI2, the gate insulating layer GI3, the interlayer insulating layer ILD, the passivation layer PVX1 and the passivation layer PVX2 includes an inorganic insulating material. For example, the inorganic insulating material includes at least one of silicon oxide, silicon nitride and silicon oxynitride.

For example, the materials of the pixel defining layer PDL and the planarization layer include organic insulating materials. For example, the planarization layer PLN1, the planarization layer PLN2, and the planarization layer PLN3 include organic insulating materials. For example, the organic insulating material includes one or a combination of several of acrylic, polyethylene terephthalate, polyimide, polyamide, polycarbonate, epoxy resin, etc.

For example, in the embodiment of the present disclosure, both the pixel defining layer PDL and the planarization layer may be referred to as an organic layer or an organic insulating layer. For example, each of the planarization layer PLN1, the planarization layer PLN2, and the planarization layer PLN3 may be referred to as an organic layer. The pixel defining layer PDL may be referred to as an organic layer. The planarization sublayer PLN3-1 may be referred to as an organic sublayer or an organic insulating sublayer, and the planarization sublayer PLN3-2 may be referred to as an organic sublayer or an organic insulating sublayer.

For example, in the embodiment of the present disclosure, the insulating layer ISL may also be referred to as an insulating material layer.

For example, in the embodiment of the present disclosure, at least one of the gate electrode GT1, the gate electrode GT2, the gate electrode GT3, the first electrode plate Ca, the second electrode plate Cb, the first electrode Ea, the second electrode Eb, the first electrode Ec, the second electrode Ed, the connection electrode CE1, the connection electrode CE2, the connection electrode CEa, the connection electrode CEb and the connection electrode CEc is made of metal or alloy.

For example, in the embodiment of the present disclosure, the active layer AT1 and the active layer AT2 are semiconductor layers and can be made of polysilicon or metal oxide semiconductor materials.

For example, in the embodiment of the present disclosure, one of the pixel electrode E1 and the common electrode E2 is an anode of the light-emitting element, and the other one of the pixel electrode E1 and the common electrode E2 is a cathode of the light-emitting element. The embodiment of the present disclosure is described with reference to the case where the pixel electrode E1 is an anode and the common electrode E2 is a cathode, by way of example.

For example, the pixel electrode E1 is made of a conductive material. For example, the material of the pixel electrode E1 includes metal and conductive metal oxide. For example, the pixel electrode E1 has a structure in which indium tin oxide (ITO), silver (Ag) and indium tin oxide (ITO) are stacked. The material and structure of the pixel electrode E1 can be configured as required.

For example, the common electrode E2 is made of a conductive material. For example, the material of the common electrode E2 includes a metal or an alloy. For example, the material of the common electrode E2 includes a Mg/Ag alloy. The material and structure of the common electrode E2 can be configured as required.

It should be noted that the embodiment of the present disclosure is described with reference to the case where the common layer CL includes a first common layer CL1, a second common layer CL2, and a third common layer CL3 by way of example, but the present disclosure is not limited to this. The common layer CL may have a single-layered structure or a stacked structure including a plurality of film layers. For example, in some embodiments, the common layer CL includes at least a charge generation layer.

For example, in the embodiment of the present disclosure, at least one film layer in the light-emitting functional layer EML can be made by an evaporation process.

It should be noted that the embodiment of the present disclosure is described with reference to the case where the light-emitting element has a tandem structure by way of example, but the present disclosure is not limited to this, and other suitable structures may also be adopted for the light-emitting element.

For example, the display panel may further include an encapsulation layer configured to encapsulate a plurality of light-emitting elements to prevent from infiltration of water and oxygen.

For example, the pixel defining layer PDL may be a black pixel defining layer. Generally, a color filter on encapsulation (COE) structure can be used along with the black pixel defining layer.

For example, the display panel may further include a touch layer, which may be arranged between the encapsulation layer and the COE structure.

In the embodiment of the present disclosure, the structures shown in the cross-sectional views of the display panel with a bending region are structures before bending. For example, the bending region at the right side in the drawings can be bent downwardly so that part of the display panel is arranged behind another part of the display panel, which is beneficial to reducing the bezel of the display panel.

It should be noted that in the embodiment of the present disclosure, the pixel circuit 100 includes a transistor T1, a transistor T2 and a storage capacitor. For example, the transistor T1 may be a light emission control transistor, and the transistor T2 may be a threshold compensation transistor or a reset control transistor, but the present disclosure is not limited thereto. The embodiment of the present disclosure is not intended to limit the structure of the pixel circuit 100, and general pixel circuits can be adopted. For example, the pixel circuit 100 may adopt a pixel circuit of 7T1C, a pixel circuit of 7T2C, a pixel circuit of 8T1C or a pixel circuit of 9T1C. Of course, the number of transistors and the number of capacitors included in the pixel circuit 100 are not limited to the above description, but may be determined as needed. The connection relationships between transistors or between transistors and capacitors are not shown in the cross-sectional views, and general structures can be adopted here.

In the drawings provided by the embodiments of the present disclosure, the plan views show the direction X and the direction Y, and the cross-sectional views show the direction Z. The direction X intersects with the direction Y. For example, the direction X is perpendicular to the direction Y. Both the direction X and the direction Y are parallel to the main surface of the base substrate. For example, the direction Z is perpendicular to the direction X and perpendicular to the direction Y.

For example, in the embodiment of the present disclosure, in the case where the separation structure 600 is made of an inorganic nonmetallic material (passivation layer PVX2), the first through hole H1 or groove GRV in the planarization layer located below the separation structure 600 may be formed after the pattern of the pixel defining layer PDL and the second through hole H2 in the planarization layer located above the separation structure 600 are formed. Of course, the manufacturing method of the display panel is not limited to the above description. For example, in some other embodiments, the first through hole H1 or the groove GRV in the planarization layer located below the separation structure 600 is formed first, and then the subsequent patterns are fabricated, until a display panel with the structure described above is obtained. The embodiments of the present disclosure are not intended to limit the manufacturing method of the display panel, and an appropriate manufacturing method can be configured as required.

An embodiment of the present disclosure further provides a display device, including any of the display panels described above.

For example, the display device can be a display device such as an organic light-emitting diode display device, and any product or component with display function including the display device such as a TV, a digital camera, a mobile phone, a watch, a tablet computer, a notebook computer, a navigator, etc. Embodiments of the present disclosure include but are not limited to this.

The above are only specific embodiments of the present disclosure, but the protection scope of the present disclosure is not limited thereto. Any person skilled in the art can easily think of changes or substitutions within the technical scope disclosed in the present disclosure. It should be covered within the protection scope of the present disclosure. Therefore, the protection scope of the present disclosure should be subject to the protection scope of the claims.

## Claims

1. A display panel, comprising:
a base substrate;
a plurality of pixel circuits located on the base substrate;
an insulating material layer located at a side of the plurality of pixel circuits facing away from the base substrate and comprising a plurality of organic insulating layers, each of the plurality of organic insulating layers comprising an organic material;
a plurality of pixel electrodes, each of the plurality of pixel electrodes being located at a side of the plurality of organic insulating layers facing away from the base substrate and connected to one pixel circuit of the plurality of pixel circuits;
a light-emitting functional layer comprising a common layer, an orthographic projection of the common layer on the base substrate overlapping with orthographic projections of the plurality of pixel electrodes on the base substrate, and at least part of the common layer being located at a side of the plurality of pixel electrodes facing away from the base substrate; and
a separation structure having a protrusion protruding from the organic insulating layer below the separation structure, or the separation structure itself having a protrusion, the separation structure being configured to disconnect the common layer at the protrusion,
wherein the separation structure is located between adjacent pixel electrodes and comprises an inorganic material, the separation structure is located on at least part of the organic insulating layer, and the separation structure is spaced apart from the plurality of pixel electrodes by at least part of the organic insulating layer.

2. The display panel according to claim 1, wherein the organic insulating layer located below the separation structure has a groove or a first through hole at the protrusion.

3. The display panel according to claim 2, wherein the organic insulating layer located above the separation structure has a second through hole at the protrusion, and the first through hole is communicated with the second through hole.

4. The display panel according to claim 3, further comprising a pixel defining layer, wherein the pixel defining layer has a plurality of first openings, each of the plurality of first openings is configured to expose one pixel electrode of the plurality of pixel electrodes, and the pixel defining layer further has a second opening which is communicated with the second through hole.

5. The display panel according to claim 4, wherein an orthographic projection of the second opening on the base substrate overlaps with an orthographic projection of the separation structure on the base substrate.

6. The display panel according to any one of claims 2-5, wherein the separation structure has one protrusion at the groove or the first through hole.

7. The display panel according to any one of claims 2-5, wherein the groove or the first through hole has an elongated shape, the separation structure comprises two separation parts at the groove or the first through hole, and the two separation parts form two protrusions respectively, and the two protrusions are located in the groove or the first through hole and located at two opposite sides of the groove or the first through hole having the elongated shape.

8. The display panel according to any one of claims 1-7, further comprising a common electrode, wherein at least part of the common electrode is located at a side of the light-emitting functional layer facing away from the base substrate, and the plurality of pixel electrodes, the light-emitting functional layer and the common electrode constitute a plurality of light-emitting elements.

9. The display panel according to claim 8, wherein the separation structure surrounding one of the plurality of light-emitting elements comprises a plurality of separation substructures.

10. The display panel according to claim 9, wherein the plurality of separation substructures comprise at least two separation substructures located at two opposite sides of a light-emitting region of the light-emitting element.

11. The display panel according to any one of claims 9-10, wherein spacing distances between at least one separation substructure of the plurality of separation substructures and two light-emitting elements adjacent thereto are not equal to each other.

12. The display panel according to claim 8, wherein the plurality of light-emitting elements comprise a first light-emitting element, a second light-emitting element and a third light-emitting element, wherein a light-emitting region of the first light-emitting element is smaller than that of the second light-emitting element, the light-emitting region of the second light-emitting element is smaller than that of the third light-emitting element, the separation structure comprises a first separation structure and a second separation structure, wherein the first separation structure is located at a periphery of the light-emitting region of the first light-emitting element, and the second separation structure is located at a periphery of the light-emitting region of the second light-emitting element.

13. The display panel according to claim 12, wherein the first separation structure comprises two first separation substructures located at two opposite sides of the light-emitting region of the first light-emitting element, and the second separation structure comprises four second separation substructures arranged around the light-emitting region of the second light-emitting element, wherein two second separation substructures of the four second separation substructures are located at two opposite sides of the light-emitting region of the second light-emitting element, and the other two second separation substructures of the four second separation substructures are located at two opposite sides of the light-emitting region of the second light-emitting element.

14. The display panel according to claim 13, wherein the light-emitting region of the first light-emitting element is surrounded by two first separation substructures and two second separation substructures located at gaps of the two first separation substructures, respectively.

15. The display panel according to claim 13 or 14, wherein the light-emitting region of the third light-emitting element is surrounded by four first separation substructures and two second separation substructures.

16. The display panel according to any one of claims 8-15, wherein the common electrode is continuous at the separation structure.

17. The display panel according to any one of claims 12-16, wherein the first light-emitting element is configured to emit green light, the second light-emitting element is configured to emit red light, and the third light-emitting element is configured to emit blue light.

18. The display panel according to any one of claims 1-17, wherein the separation structure is not in contact with the plurality of pixel electrodes.

19. The display panel according to any one of claims 1-18, wherein the separation structure comprises a passivation layer configured to form the protrusion, the inorganic material comprises an inorganic nonmetal material, and the inorganic material is an insulating material.

20. The display panel according to any one of claims 1-19, wherein the inorganic material comprises a metal material, and the separation structure comprises a first sublayer, a second sublayer and a third sublayer which are stacked and arranged in sequence, wherein the first sublayer is closer to the base substrate than the third sublayer to the base substrate, and the third sublayer protrudes outwardly relative to the second sublayer to form the protrusion.

21. The display panel according to any one of claims 1-20, wherein the plurality of organic insulating layers comprise a first organic insulating layer, a second organic insulating layer, and a third organic insulating layer which are sequentially arranged, wherein the first organic insulating layer is closer to the base substrate than the third organic insulating layer to the base substrate, and the separation structure is located above at least part of the first organic insulating layer and located below at least part of the third organic insulating layer in a direction perpendicular to the base substrate.

22. The display panel according to claim 21, further comprising a first connection electrode and a second connection electrode, wherein the pixel circuit comprises a transistor, the first connection electrode is located on the first organic insulating layer and connected to the transistor through a via hole passing through the first organic insulating layer, the second connection electrode is located on the second organic insulating layer and connected to the first connection electrode through a via hole passing through the second organic insulating layer, the pixel electrode is located on the third organic insulating layer and connected to the second connection electrode through a via hole passing through the third organic insulating layer.

23. The display panel according to claim 22, wherein the insulating material layer further comprises an inorganic insulating layer located between the transistor and the first organic insulating layer, and the first connection electrode also passes through the inorganic insulating layer.

24. The display panel according to any one of claims 1-23, wherein the display panel has a bending region.

25. The display panel according to any one of claims 1-24, wherein the display panel has a hole region and is provided with a plurality of separation structures, and at least part of the separation structures are located in a bezel region close to the hole region.

26. A display device, comprising the display panel according to any one of claims 1-25.
